# EUROPEAN PATENT APPLICATION

(11) **EP 4 607 587 A1**
(43) Date of publication of application: **27.08.2025**
(21) Application number: 24195270.4
(22) Date of filing: 20.08.2024
(51) Int. Cl.: H01L 23/48, H01L 23/522, H01L 25/065, H01L 25/18, H01L 25/00, H10D 84/40, H10D 84/80, H10D 88/00

(54) **FOLDED CASCODE LOW NOISE AMPLIFIER**

(30) Priority: 21.02.2024 US 202418583397
(71) Applicant: GlobalFoundries U.S. Inc., Malta, NY 12020 (US)
(72) Inventor: Kakara, Hari Kishore, 560045 Bangalore (IN); Das, Indrajit, 560045 Bangalore (IN); Vanukuru, Venkata Narayana Rao, 560045 Bangalore (IN)
(74) Representative: Grünecker Patent- und Rechtsanwälte PartG mbB

(57) **Abstract**

A disclosed low noise amplifier (LNA) includes a common-emitter amplifier (CE-A), a common-gate amplifier (CG-A) and various passive devices in CE-A and CG-A. CE-A includes an NPN-type bipolar junction transistor (BJT) with emitter and collector (E/C) regions and a base region between the E/C regions and connected to an input node. CG-A includes P-channel field effect transistor (PFET) with source and drain (S/D) regions, a channel region between the S/D region, and a gate adjacent to the channel region. The drain region of the PFET is connected to an output node. Additionally, a common inductor, collector region of the BJT, and source region of the PFET are connected at an intermediate node. The LNA is implemented on a three-dimensional integrated circuit (3DIC) with the BJT and FET on different chips and with passive devices in back end of the line regions between the BJT and FET.

## Description

### BACKGROUND

The present disclosure relates to amplifier circuits, and more particularly, to low noise amplifiers (LNAs).

LNAs are important for use in a variety of different applications. Ultra-low power LNAs are particularly important for use in satellite-based applications, such as global positioning systems (GPSs) and global navigation satellite systems (GNSs). An ultra-low power LNA can, for example, have a direct current (DC) power rating of approximately 2mW. Ideally, such ultra-low power LNAs will exhibit high gain and high linearity (e.g., specified as a third order intercept point (IIP3)) without significantly degrading the noise factor (NF). Cascode LNAs (also referred to herein as multi-stage LNAs) that include bipolar junction transistor (BJT)-based amplifiers in each stage have developed for ultra-low power operation. However, these ultra-low power cascode LNAs tend to exhibit either high gain or high linearity, but not both.

### SUMMARY

Disclosed herein are embodiments of a structure including a cascode LNA. The LNA can include a bipolar junction transistor (BJT). The BJT can include an emitter region, a collector region, and a base region between the emitter and collector regions. The base region of the BJT can further be connected to an input node. The LNA can also include a field effect transistor (FET). The FET can include a source region, a drain region, a channel region between the source and drain regions, and a gate adjacent to the channel region. The source region of the FET can be connected to the collector region of the BJT. Additionally, the drain region of the FET can be connected to an output node. In some embodiments of the disclosed structure, the BJT and FET can be on different chips of a three-dimensional integrated circuit (3DIC).

For example, a disclosed structure embodiment can include a cascode LNA. The LNA can include a BJT on a first chip. The BJT can include an emitter region, a collector region, and a base region between the emitter and collector regions. The base region of the BJT can further be connected to an input node. The LNA can further include a FET on a second chip that is stacked on the first chip. The FET can include a source region, a drain region, a channel region between the source and drain regions, and a gate adjacent to the channel region. The source region of the FET can be connected to the collector region of the BJT. Additionally, the drain region of the FET can be connected to an output node.

Another disclosed structure embodiment can similarly include a cascode LNA. In this case, the LNA can include a FET can be on a first chip and a BJT on a second chip that is stacked on the first chip. As in the previously described embodiments, the BJT can include an emitter region, a collector region, and a base region between the emitter and collector regions. The base region of the BJT can further be connected to an input node. Additionally, the FET can include a source region, a drain region, a channel region between the source and drain regions, and a gate adjacent to the channel region. The source region of the FET can be connected to the collector region of the BJT.

It should be noted that all aspects, examples, and features of disclosed embodiments mentioned in the summary above can be combined in any technically possible way. That is, two or more aspects of any of the disclosed embodiments, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The present disclosure will be better understood from the following detailed description with reference to the drawings, which are not necessarily drawn to scale and in which:
FIG. 1 is a schematic diagram illustrating disclosed embodiments of a low noise amplifier (LNA);
FIGs. 2 and 3 are cross-section diagrams illustrating examples of a BJT and a FET, respectively, that could be incorporated into the LNA of FIG. 1;

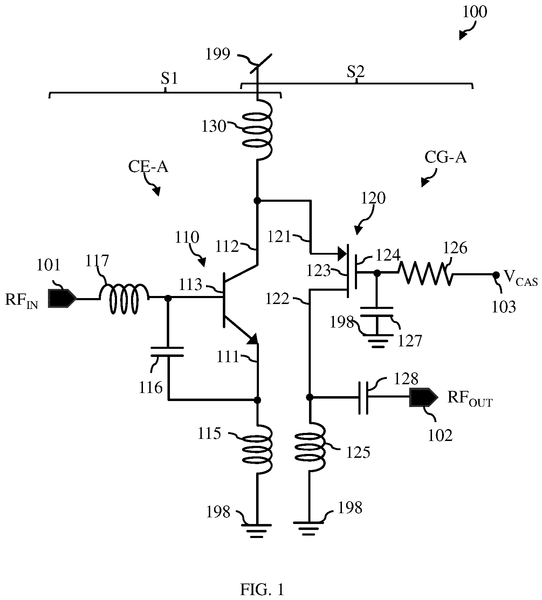

FIGs. 4A-1, 4A-2, 4B-1 and 4B-2 are layout diagrams illustrating examples of different inductors that could be incorporated into the LNA of FIG. 1;

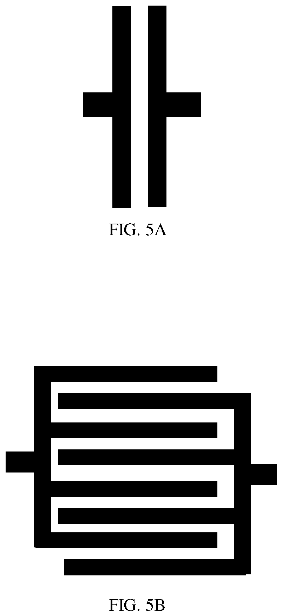

FIGs. 5A-5B are layout diagrams illustrating examples of different capacitors that could be incorporated into the LNA of FIG. 1;

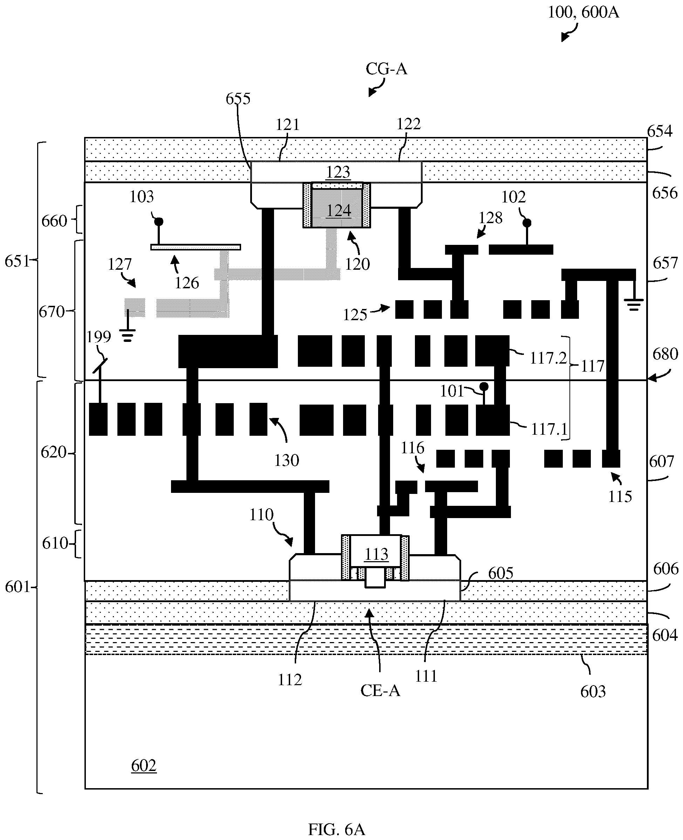

FIGs. 6A-6B are cross-section diagrams illustrating different three-dimensional integrated circuits (3DICs), respectively, including the LNA of FIG. 1; and
FIGs. 7.1-7.3 are cross-section diagrams illustrating a method of forming a 3DIC including the LNA of FIG. 1.

### DETAILED DESCRIPTION

As mentioned above, ideally, ultra-low power LNAs will exhibit both high gain and high linearity without significantly degrading the noise factor (NF) (i.e., the ratio of the signal to noise ratio at the input to the signal to noise ratio at the output). Cascode LNAs (also referred to herein as multi-stage LNAs) that include BJT-based amplifiers in each stage have developed for ultra-low power operation. However, these ultra-low power cascode LNAs tend to exhibit either high gain or high linearity, but not both.

In view of the forgoing, disclosed herein are embodiments of a cascode LNA (referred to hereinafter as the LNA). The LNA can include a common-emitter amplifier (CE-A) in an input stage (S1) and a common-gate amplifier (CG-A) in an output stage (S2). CE-A can include a bipolar junction transistor (BJT) (including an emitter region, a collector region, a base region between the emitter and collector regions ) and various passive devices connected to the BJT. Additionally, the base region of the BJT can be connected to an input node for receiving a radio frequency input signal (RFin). The BJT can be, for example, an NPN-type BJT with the base region including silicon germanium (SiGe). CG-A can include a field effect transistor (FET) (including a source region, a drain region, a channel region between the source region and the drain region, and a gate adjacent to the channel region) and various passive devices connected to the FET. Additionally, the source region of the FET can be connected to the collector region of the BJT and the drain region of the FET can be connected to an output node for outputting a radio frequency output signal (RFout). The FET can be, for example, a P-channel FET (PFET) having a silicon active device region. In some embodiments, the LNA can be included in a three-dimensional integrated circuit (3DIC). In this case, the BJT of CE-A and FET of CG-A can be on different chips of the 3DIC and various passive devices of the two amplifiers can be contained within the interlayer dielectric (ILD) material and back end of the line (BEOL) metal levels that separate the BJT and FET. The LNA can operate at low power or even ultra-low power (e.g., with a DC power rating of approximately 2 milliwatts (mW)) and can exhibit relatively high gain (e.g., at or above 20 decibels (dB)), relatively high linearity (e.g., specified as a third order intercept point (IIP3) at or above -12 decibel-milliwatts (dBm)) and a noise factor (NF) of 0.5dB to 1.0dB (e.g., an NF of 0.7dB). As compared to known ultra-low power cascode LNAs (e.g., that include only BJTs), the LNA may exhibit only a minimal reduction in gain, essentially no change in NF, and a beneficial significant increase in linearity (e.g., in IIP3).

FIG. 1 is a schematic diagram illustrating disclosed embodiments of a LNA 100. The LNA 100 can be a cascode LNA. That is, it can include multiple stages and, particularly, an input stage (S1) and an output stage (S2) electrically connected to S1. S1 can include a common-emitter amplifier (CE-A). The CE-A can include a bipolar junction transistor (BJT) 110 and first passive devices (including, for example, inductors 115 and 117 and capacitor 116) connected to BJT 110. S2 can include a common-gate amplifier (CG-A) including a field effect transistor (FET) 120 and second passive devices (including, for example, an inductor 125, capacitors 127 and 128, and a resistor 126) connected to FET 120. S1 and S2 can also share a common inductor 130, which is connected to both BJT 110 of CE-A and FET 120 of CG-A. BJT 110 of CE-A can specifically be an NPN-type BJT, whereas FET 120 of CG-A can specifically be a P-channel FET (PFET).

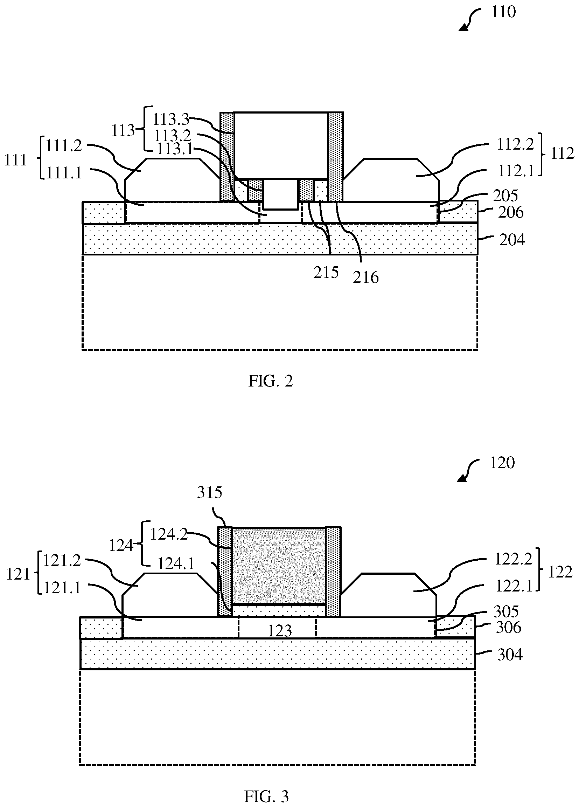

FIG. 2 is a cross-section diagram illustrating an example of an NPN-type BJT 110 that could be incorporated into CE-A. The example NPN-type BJT 110 shown in FIG. 2 is a semiconductor-on-insulator, symmetric, lateral, NPN-type heterojunction bipolar transistor (HBT) (also referred to herein as a SiGe NPN-type BJT).

Specifically, in this example, NPN-type BJT 110 is on an insulator layer 204. Insulator layer 204 can be, for example, a silicon dioxide layer or a layer of any other suitable insulator material. At least during processing, insulator layer 204 can be on a monocrystalline semiconductor substrate (e.g., a monocrystalline silicon substrate or a monocrystalline substrate of any other suitable semiconductor material).

NPN-type BJT 110 can include an active device region defined in a semiconductor layer 205 on insulator layer 204. Semiconductor layer 205 can be a first semiconductor material (e.g., monocrystalline Si). The shape of the active device region can be defined by isolation regions 206 (e.g., shallow trench isolation (STI) regions) that extend through semiconductor layer 205 at least to and, optionally, into or through insulator layer 204.

NPN-type BJT 110 can include an emitter region 111 and a collector region 112 with N-type conductivity. NPN-type BJT 110 can further include a base region 113 positioned laterally between emitter and collector regions 111 and 112 and having P-type conductivity. More specifically, emitter and collector regions 111 and 112 can include N-doped regions 111.1 and 112.1, respectively, of semiconductor layer 205. Optionally, emitter and collector regions 111 and 112 can further include N-doped monocrystalline epitaxial semiconductor layers 111.2 and 112.2 of the first semiconductor material (e.g., Si) above and immediately adjacent to regions 111.1 and 112.1, respectively. As illustrated, the emitter and collector regions 111 and 112 can be essentially symmetric.

In a standard BJT, base region 113 would, like emitter and collector regions 111 and 112, be made of the first semiconductor material (e.g., Si). In this example, the BJT is more specifically an HBT. That is, base region 113 can include, at least in part, a second semiconductor material (e.g., silicon germanium (SiGe)) that is different from the first semiconductor material (e.g., Si). Those skilled in the art will recognize that the use of differing semiconductor materials at the emitter-base junction and at base-collector junction creates heterojunctions suitable for handling higher frequencies. Thus, for example, base region 113 can include an undoped or P-doped region 113.1 of semiconductor layer 205 positioned laterally between N-doped regions 111.1 and 112.1 of emitter and collector regions 111 and 112. Optionally, semiconductor layer 205 can be recessed at region 113.1 so that region 113.1 is shorter in height than adjacent regions 111.1 and 112.1. Region 113.1 can function, during processing, as a seed layer for growth of additional epitaxial layers of base region 113. That is, base region 113 can further include an undoped or P-doped epitaxial semiconductor layer 113.2 of the second semiconductor material (e.g., SiGe) on region 113.1. This epitaxial semiconductor layer 113.2 can, for example, be selectively grown on region 113.1 so that it is monocrystalline in structure and so that it fills a relatively narrow lower base opening, which is defined by a space between first sidewall spacers 215. As illustrated, first sidewall spacers 215 can be multilayered. Base region 113 can further include a P-doped epitaxial semiconductor layer 113.3 of the first or second semiconductor materials (e.g., Si or SiGe) above and immediately adjacent to epitaxial semiconductor layer 113.2. This epitaxial layer 113.3 can, for example, be non-selectively grown such that it is polycrystalline in structure. Additionally, it can extend laterally over first sidewall spacers 215 so as to be wider than epitaxial semiconductor layer 113.2 and it can have vertical sidewalls. Additional first sidewall spacers 216 can be positioned laterally adjacent to the vertical sidewalls so as to isolate epitaxial semiconductor layer 113.3 of base region 113 from epitaxial semiconductor layers 111.2 and 112.2 of emitter and collector regions 111 and 112, respectively.

It should be understood that the example NPN-type BJT 110 shown in FIG. 2 is provided for illustration purposes and is not intended to be limiting. Alternatively, the NPN-type BJT 110 incorporated into CE-A of LNA 100 could have any other suitable configuration. For example, NPN-type BJT 110 could be a bulk semiconductor structure as opposed to a semiconductor-on-insulator structure (as illustrated), NPN-type BJT 110 could be a standard BJT as opposed to an HBT (as illustrated), NPN-type BJT 110 could be a vertical device as opposed to a lateral device (as illustrated), NPN-type BJT 110 could be an asymmetric device as opposed to a symmetric device (as illustrated), etc. In any case, as illustrated in FIG. 1, NPN-type BJT 110 includes at least emitter and collector regions 111 and 112 and a base region 113 positioned between emitter and collector regions 111 and 112.

Referring again to FIG. 1, CE-A can further include various first passive devices electrically connected to BJT 110. The first passive devices can include, but are not limited to, inductors 115 and 117 and capacitor 116, as illustrated. Specifically, CE-A can include an emitter inductor 115 electrically connected at opposite end terminals to emitter region 111 and to ground 198. CE-A can further include a base inductor 117 electrically connected at opposite end terminals to an input node 101 (which receives a radio frequency input signal (RFin)) and to base region 113. CE-A can further include an emitter-base capacitor 116, which has a pair of conductive plates that are separated by a capacitor dielectric and which are electrically connected to emitter region 111 and to base region 113, respectively. It should be noted that another inductor (referred to herein as common inductor 130 because it is common to both S1 and S2) has opposite end terminals electrically connected to a positive voltage rail 199 for receiving a positive supply voltage (VCC) and electrically connected to an intermediate node 104 and thereby to collector region 112 (as well as to FET 120, as discussed further below).

FIG. 3 is a cross-section diagram illustrating an example of a FET 120 that could be incorporated into CG-A as FET 120. FET 120 shown in FIG. 3 is a semiconductor-on-insulator, symmetric, planar, P-channel FET (PFET).

Generally, in this example, PFET 120 is on an insulator layer 304. Insulator layer 304 can be, for example, a silicon dioxide layer or a layer of any other suitable insulator material. At least during processing, insulator layer 304 can be on a monocrystalline semiconductor substrate (e.g., a monocrystalline silicon substrate or a monocrystalline substrate of any other suitable semiconductor material).

PFET 120 can include an active device region defined in a semiconductor layer 305 on insulator layer 304. Semiconductor layer 305 can be a first semiconductor material (e.g., monocrystalline Si). The shape of the active device region can be defined by isolation regions 306 (e.g., shallow trench isolation (STI) regions) that extend through semiconductor layer 305 at least to and, optionally, into or through insulator layer 304.

PFET 120 can include source and drain regions 121 and 122 with P-type conductivity, a channel region 123 positioned laterally between source and drain regions 121 and 122 and having P-type conductivity, and a gate 124 adjacent to the channel region 123. More specifically, source and drain regions 121 and 122 can include P-doped regions 121.1 and 122.1, respectively, of semiconductor layer 305. Optionally, source and drain regions 121 and 122 can further include P-doped monocrystalline epitaxial semiconductor layers 121.2 and 122.2 (also referred to herein as raised source and drain regions) of the first semiconductor material (e.g., Si) above and immediately adjacent to regions 121.1 and 122.1, respectively. As illustrated, the source and drain regions 121 and 122 can be essentially symmetric. Channel region 123 can include a region of semiconductor layer 305 positioned laterally between P-doped regions 121.1 and 122.1 of source and drain regions 121 and 122. Channel region 123 can be either undoped (i.e., an intrinsic channel region) or doped so as to have N-type conductivity at a relatively low conductivity level. Gate 124 can include a gate dielectric layer 124.1 (including one or more layers of gate dielectric material) on the top surface of semiconductor layer 305 at channel region 123) and a gate conductor layer 124.2 (including one or more layers of gate conductor material on the gate dielectric layer 124.1. Gate 124 can be, for example, a gate first gate high-K metal gate structure or any other suitable gate structure. Gate sidewall spacers 315 can electrically isolate gate 124 from source and drain regions 121 and 122.

PFET structures as described above are well known in the art and, thus, more specific details thereof (including additional features that may be incorporated into such a PFET) have been omitted from the specification in order to allow the reader to focus on the salient aspects of the disclosed embodiments related to inclusion generally of a PFET in CG-A of LNA 100, as illustrated in FIG. 1. Furthermore, it should be understood that the configuration of the PFET 120 shown in FIG. 3 is provided for illustration purposes and is not intended to be limiting. Alternatively, PFET 120 incorporated into CG-A of LNA 100 could have any other suitable configuration. For example, PFET 120 could be a bulk semiconductor structure as opposed to a semiconductor-on-insulator structure (as illustrated), a non-planar PFET as opposed to a planar PFET (as illustrated), a multi-gate finger PFET as opposed to a single gate PFET (as illustrated), an asymmetric PFET as opposed to a symmetric PFET (as illustrated), etc. In any case, as illustrated in FIG. 1, PFET 120 includes a source and drain regions 121 and 122, a channel region 123 between source and drain regions 121 and 122, and a gate 124 adjacent to the channel region 123. Various different PFET structures are well known in the art and could instead be incorporated into CG-A of LNA 100.

Referring again to FIG. 1, source region 121 of PFET 120 can be electrically connected to collector region 112 of NPN-BJT 110 and to common inductor 130 at intermediate node 104. CG-A can further include various second passive devices electrically connected to PFET 120. The second passive devices can include, but are not limited to, an inductor 125, capacitors 127 and 128, and a resistor 126, as illustrated. Specifically, CG-A can include a drain inductor 125 electrically connected at opposite end terminals to drain region 122 and to ground 198. CG-A can further include a gate capacitor 127, which has a pair of conductive plates that are separated by a capacitor dielectric and which are electrically connected to gate 124 and to ground 198, respectively. CG-A can further include an output capacitor 128, which has a pair of conductive plates that are separated by a capacitor dielectric and which are electrically connected to drain region 122 and to an output node 102, respectively. A radio frequency output signal (RFout) can be output at output node 102 in response to RFin received at input node 101. CG-A can further include a resistor 126 (also referred to herein as a gate resistive element) with opposing end terminals electrically connected to gate 124 and to a bias voltage node 103 (e.g., for receiving a bias voltage (Vcas)).

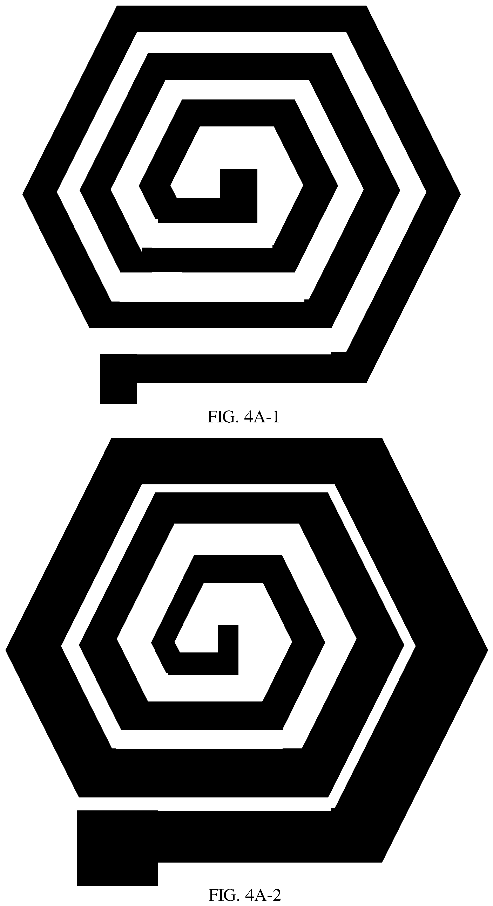

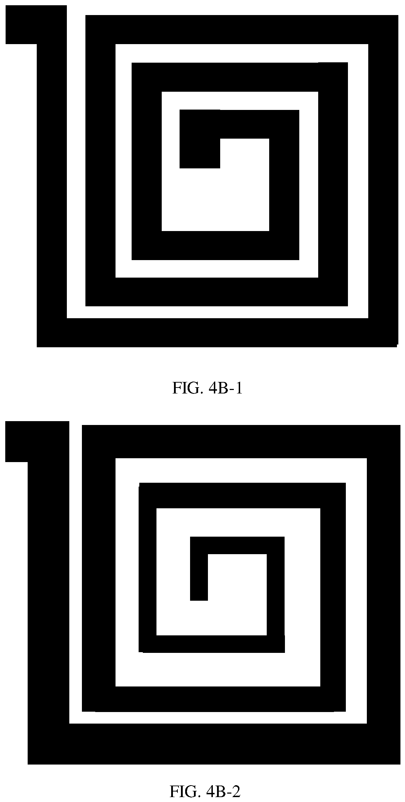

An inductor refers to a two-terminal electronic device that stores energy in a magnetic field when current flows through the device. An inductor typically includes an insulated wire wound in a spiral or coil shape. Within an IC, inductors can be formed in back end of the line (BEOL) metal levels and electrically connected to front end of the line (FEOL) devices (e.g., BJTs, FETs, etc.) via interconnects (including, for example, middle of the line (MOL) contacts and BEOL vias and/or wires). FIGs. 4A-1, 4A-2, 4B-1 and 4B-2 are layout diagrams illustrating examples of BEOL spiral-shaped planar inductors that could be incorporated into CE-A and CG-A or as common inductor 130. Specifically, FIGs. 4A-1 illustrates hexagon spiral-shaped planar inductor where the BEOL wire is patterned to have a uniform width from one end to the other. FIGs. 4A-2 illustrates hexagon spiral-shaped planar inductor where the BEOL wire is patterned to have a tapering width from an outside end to an inside end at the center of the spiral. FIGs. 4B-1 illustrates square spiral-shaped planar inductor where the BEOL wire is patterned to have a uniform width from one end to the other. FIGs. 4B-2 illustrates square spiral-shaped planar inductor where the BEOL wire is patterned to have a tapering width from an outside end to an inside end at the center of the spiral. The hexagon and square shapes of the spiral inductors illustrated in FIGs. 4A-1 and 4A-2 and in FIGs. 4B-1 and 4B2, respectively, are provided for illustration purposes. Alternatively, any other suitable spiral shape could be employed (e.g., circular, etc.). A capacitor refers to another two-terminal electronic device that stores energy in an electric field by accumulating charges on oppositely charged conductive plates insulated from each other by a capacitor dielectric. Within an IC, capacitors can be formed in BEOL metal levels and electrically connected to FEOL devices (e.g., BJTs, FETs, etc.) via interconnects (including, for example, MOL contacts and BEOL vias and/or wires). FIGs. 5A and 5B are layout diagrams illustrating examples of BEOL conventional plate and interdigitated capacitors that could be incorporated into CE-A and CG-A of LNA 100. A resistor is a two-terminal electronic device that provide resistance to current flow (e.g., to bias active elements, adjust signal levels, etc.). Within an IC, resistors can be formed in BEOL metal levels (e.g., thin film resistors), as MOL structures (e.g., polysilicon resistors), or even as FEOL structures (e.g., silicon resistors). The passive devices mentioned above and included within LNA 100 could have any now known or subsequently developed configuration.

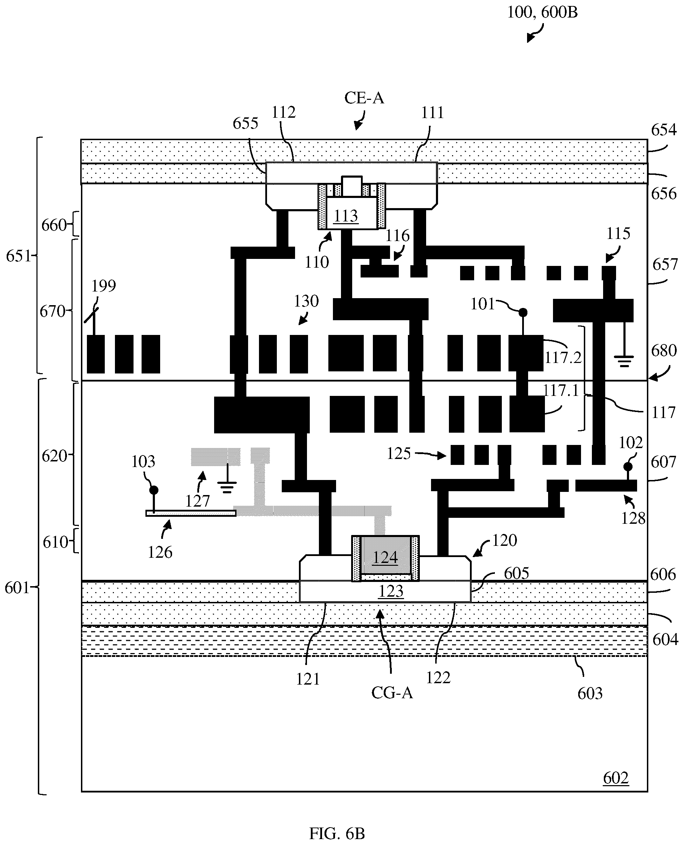

In embodiments disclosed herein, LNA 100 can be implemented on a three-dimensional integrated circuit (3DIC). FIGs. 6A and 6B are cross-section diagrams illustrating embodiments of LNA 100 implemented on a 3DIC structure 600A and 600B, respectively. In each of these embodiments, 3DIC structure 600A, 600B can include a first chip 601 (also referred to herein as a bottom chip ) and a second chip 651 (also referred to herein as a top chip).

First chip 601 can include a semiconductor substrate 602. Semiconductor substrate 602 can be a monocrystalline silicon substrate or a substrate of any other suitable monocrystalline semiconductor material. First chip 601 can further include a first insulator layer 604 on semiconductor substrate 602. First insulator layer 604 can be, for example, a silicon dioxide layer or a layer of any other suitable insulator material. Optionally, semiconductor substrate 602 can include a high resistance region 603 (also referred to herein as a trap-rich region) adjacent to first insulator layer 604.

High resistance region 603 can be a defect region. This defect region can be polycrystalline or amorphous in structure and can include imperfections in the regular spacing of atoms that make up the semiconductor material. These imperfections form traps and, specifically, locations within the semiconductor substrate that restrict movement of charge carriers (i.e., electrons and holes) so that this defect region is referred to as being a trap-rich region. The presence of these imperfections or traps increases resistance so that this defect region is also referred to as a high resistance region. As discussed in greater detail below regarding the method embodiments, an exemplary technique for forming such a high resistance region 603 can include implantation of an inert dopant to modify substrate crystalline structure (e.g., to convert it to an amorphous structure). For purposes of this disclosure, an inert dopant refers to a dopant species that is generally not considered to be chemically reactive (i.e., that is neutral) at least with respect to the particular semiconductor material of the semiconductor substrate, that does not completely prevent recrystallization of the doped region during a subsequent rapid thermal anneal process (RTA) (e.g., to create poly and/or monocrystalline region(s)), and that does not significantly impact the electrical properties of the resulting poly and/or monocrystalline region(s). Such inert dopants include, but are not limited to, inert gases (also referred to as noble gases) (e.g., argon, xenon, helium, neon, krypton, radon, etc.), silicon, or any other suitable inert dopant. The inert dopant implantation process is followed by a recrystallization anneal during which the amorphized portion begins to recrystallize from the top down and from the bottom up and, as a result, the defect region is formed. Thus, if semiconductor substrate 602 includes a high resistance region 603, the inert dopant will be present below, within, and above the high resistance region 603.

First chip 601 can include one of the transistors of one of the amplifiers (CE-A or CG-A) of LNA 100 on first insulator layer 604. For example, first chip 601 can include NPN-type BJT 110 (as described in detail above) on first insulator layer 604 (e.g., see 3DIC 600A of FIG. 6A). Alternatively, first chip 601 can include PFET 120 (as described in detail above) on first insulator layer 604 (e.g., see 3DIC 600B of FIG. 6B). Isolation regions 606 (e.g., shallow trench isolation (STI) regions) can be on first insulator layer 604 positioned laterally adjacent to the transistor.

First chip 601 can include multiple first dielectric material layers 607. First dielectric material layers 607 can include one or more first dielectric material layers in a first MOL region 610 adjacent to STI regions 606 and further over first front end of the line (FEOL) devices on first insulator layer 604, including either NPN-type BJT 110 (as in FIG. 6A) or PFET 120 (as in FIG. 6B). The first MOL region 610 can further include first contacts extending therethrough to the first FEOL device(s). The first dielectric material layers 607 can further include multiple first dielectric material layers in a first BEOL region 620 (including first BEOL metal levels therein) adjacent to first MOL region 610.

Second chip 651 can include a second insulator layer 654. Second insulator layer 654 can be, for example, a silicon dioxide layer or a layer of any other suitable insulator material. Second chip 651 can include one of the transistors of LNA 100 on second insulator layer 654. For example, if first chip 601 includes NPN-type BJT 110 on first insulator layer 604, then second chip 651 can include PFET 120 on second insulator layer 654 (e.g., see 3DIC 600A of FIG. 6A). Alternatively, if first chip 601 includes PFET 120 on first insulator layer 604, then second chip 651 can include NPN-type BJT 110 on second insulator layer 654 (e.g., see 3DIC 600B of FIG. 6B). Isolation regions 656 (e.g., shallow trench isolation (STI) regions) can be below and immediately adjacent to second insulator layer 654, and hence laterally adjacent to the transistor.

Second chip 651 can include multiple second dielectric material layers 657. Second dielectric material layers 657 can include one or more second dielectric material layers in a second MOL region 660 adjacent to STI regions 656 and further extend below second FEOL devices, including either PFET 120 (as in FIG. 6A) or NPN-type BJT 110 (as in FIG. 6B). The second MOL region 660 can further include second contacts extending therethrough to the second FEOL device(s). The second dielectric material layers 657 can further include multiple second dielectric material layers in a second BEOL region 670 (including second BEOL metal levels therein) adjacent to second MOL region 660.

Second chip 651 can further be flipped relative to first chip 601 and outermost surfaces of BEOL regions 620, 670 of the two chips 601, 651 can be bonded together or otherwise connected (see bonded surfaces 680). Specifically, bonded surfaces 680 can be physically attached to each other and can have bonding elements in electrical communication with each other.

In these embodiments, at least some of the passive devices mentioned above (including, but not limited to, inductors 130, 115, 117 and 125 and capacitors 116, 127, and 128) can be included in the BEOL regions 620 and/or 670 between NPN-type BJT 110 and PFET 120. Optionally, one or more of these passive devices could have portions included in BEOL region 620 of first chip 601 and BEOL region 670 of second chip 651. For example, any of the inductors 130, 115, 117, and/or 125 and any of capacitors 116, 127, and/or 128 could have a first portion, which is in BEOL region 620 of first chip 601 and a second portion, which is in BEOL region 670 of second chip 651, stacked above, and connected in parallel to the first portion. By stacking different portions of passive device(s) in the BEOL regions of chips 601 and 651 of 3DIC 600A or 600B and further connecting them in parallel, 3DIC area is reduced. Furthermore, by specifically stacking different portions of any inductor in the BEOL regions of chips 601 and 651 a relatively high quality factor (also referred to as a high-Q) can be achieved. Those skilled in the art will recognize the quality factor (Q) of an inductor refers the ratio of its inductive reactance to its resistance at a given frequency and is a measure of its efficiency. The higher the Q factor of the inductor, the closer it approaches the behavior of an ideal inductor.

For purposes of illustration, base inductor 117 is shown as including a first portion 117.1 in a top (thickest) metal level of BEOL region 620 and a second portion 117.2 within top (thickest) metal level of BEOL region 670. Second portion 117.2 can be aligned above first portion 117.1 and can further be connected in parallel to first portion 117.1 (e.g., by vias bonded together at bonded surfaces 680). First portion 117.1 and second portion 117.2 can have the same dimensions (e.g., same wire thickness (height), same wire width, same wire length, etc.). Alternatively, first portion 117.1 and second portion 117.2 can have different dimensions (e.g., different wire thicknesses. etc.). In any case, by including the two portions 117.1 and 117.2 thick metal levels, stacking them, and connecting them in parallel, base inductor 117 has a high-Q.

Any of inductors 130, 115, 117, and/or 125 can have uniform wire widths between their respective end terminals (e.g., as shown in FIGs. 4A-1 or 4B-1) or can have tapered wire widths from the outer end terminal to the inner end terminal (e.g., as shown in FIGs. 4A-2 or 4B-2). For purposes of illustration, base inductor 117 is specifically shown in FIGs. 6A and 6B as being a tapered spiral inductor. In this case, the wire widths of first and second portions 117.1-117.2 decrease from their respective outer ends to their respective inner ends. As mentioned above, base inductor 117 extends between input node 101 and base 113 of NPN-BJT 110. By forming this base inductor 117 as a tapered spiral inductor, the noise factor of the LNA 100 can be maintained at a relatively low level between 0.5dB and 1.0dB (e.g., an NF of 0.7dB).

Resistor 126 can be, for example, a thin film resistor included within a BEOL region (as illustrated). Alternatively, resistor 126 could be included within a MOL region (e.g., an undoped or low-doped polysilicon resistor or any other now known or subsequently developed MOL resistor) or included within as a FEOL device (e.g., an undoped or low-doped monocrystalline silicon resistor or any other now know or subsequently developed FEOL resistor). Required electrical connections between the LNA components can include a combination of contacts in MOL regions 610, 660 and vias/metal wires in BEOL regions 620, 670.

FIGs. 6A and 6B are provided to illustrate NPN-BJT 110 of CE-A and PFET 120 of CG-A of LNA 100 on different chips 601, 651 of a 3DIC and to further show that the various passive devices of CE-A and CG-A can be included within the interlayer dielectric material and metal levels between CE-A and CG-A of LNA 100 (i.e., MOL region 610, BEOL region 620, BEOL region 670, and/or MOL region 660). FIGs. 6A and 6B are not intended to be limiting. It should be understood that in order to meet required performance specifications and to comply with design rules for the particular technology node at issue the various passive devices described above and connected to NPN-type BJT 110 and PFET 120 can be placed at different levels and/or at different locations within MOL and BEOL regions, can have different sizes, can have different configurations, etc. as compared to the passive devices illustrated.

Also disclosed herein are method embodiments for forming the 3DIC structures 600A and 600B described above and illustrated in FIGs. 6A and 6B, respectively. FIG.s 7.1-7.3 described below illustrate specifically formation of the 3DIC structure 600A of FIG. 6A wherein NPN-type BJT 110 is formed on a first chip 601 and PFET 120 is formed on a second chip 651. However, essentially the same process steps could be employed to form the 3DIC 600B of FIG. 6B except that PFET 120 would be formed on first chip 601 and NPN-type BJT 110 would be formed on second chip 651.

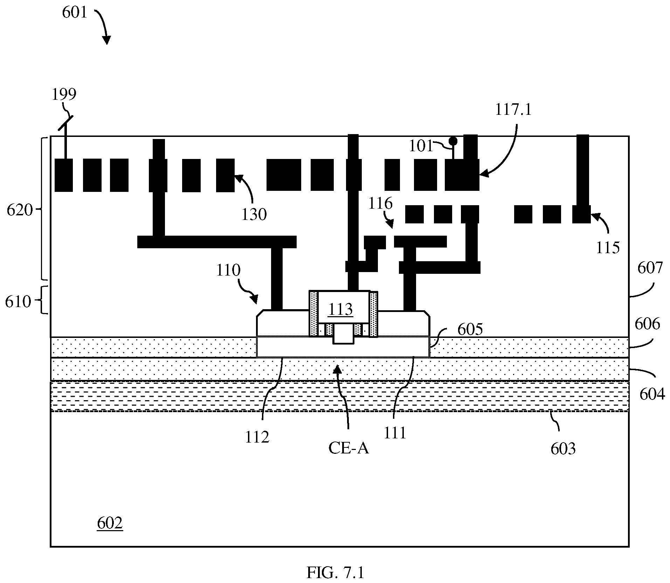

The methods can include forming a first chip (e.g., see first chip 601 in FIG. 7.1). Formation of the first chip 601 can begin with a first semiconductor-on-insulator structure. The first semiconductor-on-insulator structure can be, for example, a silicon-on-insulator (SOI) structure including: a first semiconductor substrate 602; a first insulator layer 604 on the first semiconductor substrate 602; and a first semiconductor layer 605 on the first insulator layer 604.

First FEOL devices, including either NPN-type BJT 110 or PFET 120, with STI regions 606 positioned laterally thereto can be formed on first insulator layer 604 using the first semiconductor layer 605. As mentioned above, the method is described herein with an NPN-type BJT 110 being formed on first chip 601. The NPN-type BJT 110 shown in FIG. 7.1 is a semiconductor-on-insulator, symmetric, lateral, NPN-type heterojunction bipolar transistor (HBT) (also referred to herein as a SiGe NPN-type BJT). However, it should be understood that FIG. 7.1 is not intended to be limiting. Alternatively, the NPN-type BJT 110 formed on first chip 601 could be a standard BJT as opposed to an HBT (as illustrated), a vertical device as opposed to a lateral device (as illustrated), an asymmetric device as opposed to a symmetric device (as illustrated), etc. In any case, as illustrated in FIG. 7.1, NPN-type BJT 110 can be formed so as to include at least emitter and collector regions 111 and 112 and a base region 113 positioned between emitter and collector regions 111 and 112. Techniques for forming such NPN-type BJTs with various different configurations are well known in the art. Thus, the details thereof have been omitted from this specification in order to allow the reader to focus on the salient aspects of LNA 100 (including inclusion of both a CE-A with an NPN-type BJT and various passive devices, a CG-A with a PFET and various passive devices, a common inductor, and the connections therebetween implemented, for example, on a 3DIC).

MOL and BEOL processing can then be performed. Such processing can include, but is not limited to: formation of first dielectric material layers 607 (including first dielectric material layer(s) in a first MOL region 610 and first dielectric material layers in a first BEOL region 620 on first MOL region 610); formation of first contacts extending through first MOL region 610 to terminals of NPN-type BJT 110; formation of first passive devices or portions thereof as described above (e.g., formation of inductor 115,capacitor 116, and first portion 117.1 of inductor 117; optional formation of common inductor 130; and formation of any required connections (as indicated in FIG. 1) to each other and to NPN-type BJT 110. It should be understood that the various first dielectric materials layers 607 are formed throughout such processing as MOL features (e.g., MOL contacts) and BEOL metal features are formed therein. Such MOL and BEOL processing techniques, including techniques for forming passive devices such as inductors, capacitors, and resistors, are well known. Thus, the details thereof have been omitted from this specification in order to allow the reader to focus on the salient aspects of LNA 100 (including inclusion of both a CE-A with an NPN-type BJT and various passive devices, a CG-A with a PFET and various passive devices, a common inductor, and the connections therebetween implemented, for example, on a 3DIC).

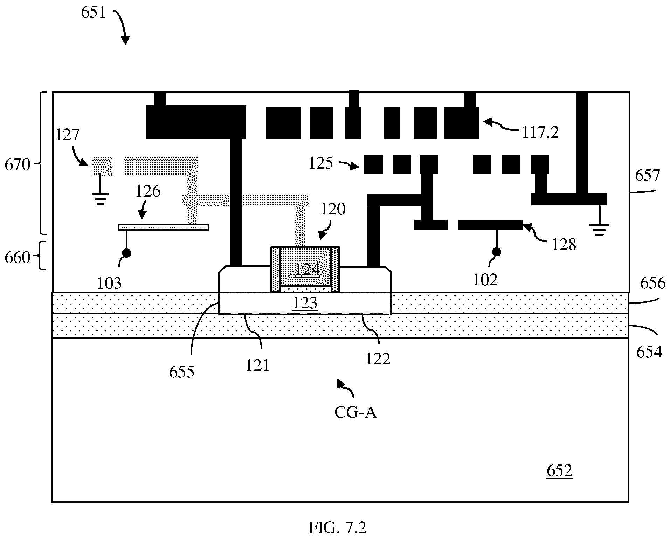

The methods can also include formation a second chip (e.g., see second chip 651 in FIG. 7.2). Formation of the second chip 651 can begin with a second semiconductor-on-insulator structure. The second semiconductor-on-insulator structure can be, for example, a silicon-on-insulator (SOI) structure including: a second semiconductor substrate 652 (also referred to herein as a sacrificial semiconductor substrate); a second insulator layer 654 on the second semiconductor substrate 652; and a second semiconductor layer 655 on second insulator layer 654.

Second FEOL devices, including PFET 120 if NPN-type BJT 110 is formed on first chip 601 or vice versa, and STI regions 656 positioned laterally thereto can be formed on second insulator layer 656 using the second semiconductor layer 655. As mentioned above, the method is described herein with an NPN-type BJT 110 being formed on first chip 601, so a PFET 120 is formed on second chip 651. The PFET 120 shown in FIG. 7.2 is a semiconductor-on-insulator, symmetric, planar PFET. However, it should be understood that FIG. 7.2 is not intended to be limiting. Alternatively, the PFET 120 formed on second chip 651 could be a bulk semiconductor structure as opposed to a semiconductor-on-insulator structure (as illustrated), a non-planar PFET as opposed to a planar PFET (as illustrated), a multi-gate finger PFET as opposed to a single gate PFET (as illustrated), an asymmetric PFET as opposed to a symmetric PFET (as illustrated), etc. In any case, as illustrated in FIG. 7.2, PFET 120 can be formed so as to include a source region 121 and a drain region 122, a channel region 123 between source and drain regions 121 and 122, and a gate 124 adjacent to the channel region 123. Techniques for forming such PFETs with various different configurations are well known. Thus, the details thereof have been omitted from this specification in order to allow the reader to focus on the salient aspects of LNA 100 (including inclusion of both a CG-A with an NPN-type BJT and various passive devices, a CG-A with a PFET and various passive devices, a common inductor, and the connections therebetween implemented, for example, on a 3DIC).

MOL and BEOL processing can then be performed. Such processing can include, but is not limited to: formation of second dielectric material layers 657 (including second dielectric material layer(s) in a second MOL region 660 and second dielectric material layers in a second BEOL region 670 on second MOL region 660); formation of second contacts extending through second MOL region 660 to terminals of PFET 120; formation of second passive devices or portions thereof described above (e.g., inductor 125, capacitors 127 and 128, resistor 126, and second portion 117.2 of inductor 117); optionally, formation of common inductor 130 (e.g., if not formed on first chip 601); and formation of any required connections (as indicated in FIG. 1) to each other and to PFET 120. It should be understood that the various second dielectric materials layers 657 are formed throughout such processing as MOL features (e.g., MOL contacts) and BEOL metal features are formed therein. Such MOL and BEOL processing techniques, including techniques for forming passive devices, such as inductors, capacitors and resistors, are well known. Thus, the details thereof have been omitted from this specification in order to allow the reader to focus on the salient aspects of LNA 100 (including inclusion of both a CE-A with an NPN-type BJT and various passive devices, a CG-A with a PFET and various passive devices, a common inductor, and the connections therebetween implemented, for example, on a 3DIC).

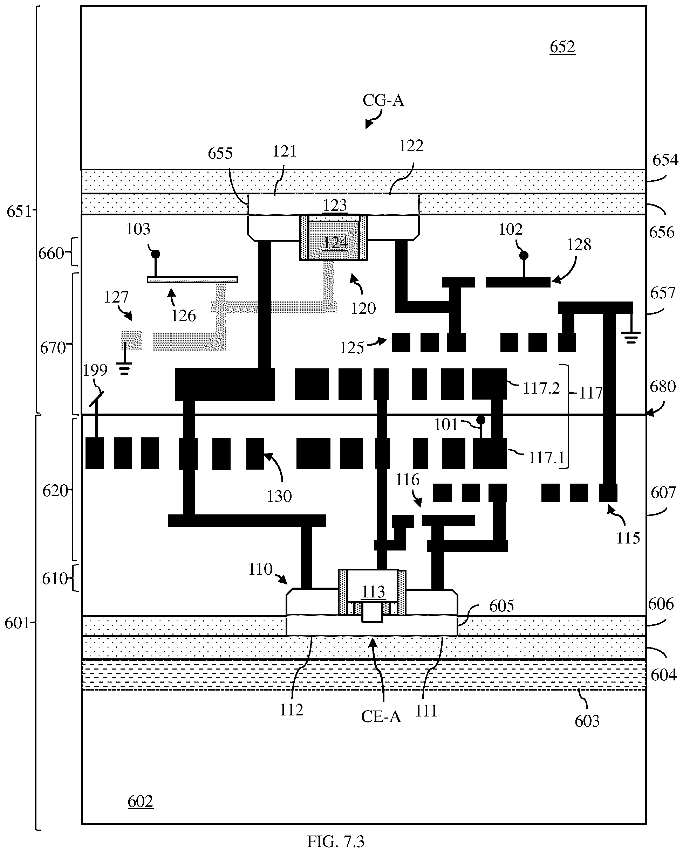

The methods can further include flipping second chip 651 relative to first chip 601 and stacking second chip 651 on first chip 601 so that outermost surfaces of first dielectric material layers 607 (distal to first FEOL devices, such as NPN-type BJT 110, on first chip 601) and second dielectric material layers 657 (distal to second FEOL devices, such as PFET 120, on second chip 651) are immediately adjacent to each other (see FIG. 7.3). It should be noted that, during BEOL processing on first chip 601 and on second chip 651, patterning of one or more features (e.g., different portions 130.1 and 130.2 of common inductor 130, of vias, etc.) can be performed so that, when second chip 651 is flipped relative to and stacked on first chip 601 these features will be vertically aligned. Then, the outermost surfaces of first dielectric material layers 607 and second dielectric material layers 657 can be bonded together (see bonded outermost surfaces 680).

Bonding can, for example, be performed using a hybrid bonding technique (e.g., a direct bond interconnect (DBI) techniques. Specifically, a hybrid bonding technique can be performed, resulting in dielectric-to-dielectric bonding of adjacent dielectric materials (e.g., of the first and second dielectric material layers) and metal-to-metal bonding (e.g., copper-to-copper bonding) of the adjacent metal materials (e.g., of different portions 130.1 and 130.2 of common inductor 130, of vertically aligned vias, etc.). Such hybrid bonding techniques are well known in the art. Thus, a detailed discussion thereof has been omitted from this specification in order to allow the reader to focus on the salient aspects of the disclosed embodiments. However, those skilled in the art will recognize that such techniques typically rely on application of both pressure and relatively high heat. Alternatively, any other suitable wafer-to-wafer, chip-to-wafer, or chip-to-chip bonding technique could be employed (e.g., bump-type bonding techniques).

The methods can further include removing second semiconductor substrate 652 (i.e., the sacrificial semiconductor substrate) to expose second insulator layer 654 (see FIG. 6A). Removal of second semiconductor substrate 652 can be achieved, for example, using a grinding process or any other suitable process. Substrate grinding techniques are well known in the art and, thus, the details thereof have been omitted from this specification in order to allow the reader to focus on the salient aspects of the disclosed embodiments.

The methods can further include additional processing to complete the 3DIC structure. This additional processing can include, but is not limited to, the following: forming an additional insulator layer on exposed surface of second insulator layer 654 (e.g., by thermal oxide deposition, chemical vapor deposition (CVD), or any other suitable insulator deposition process); optionally, performing a polishing process (e.g., a chemical mechanical polishing (CMP) process); forming through oxide vias (TOVs); forming input/output pads on the TOVs, etc.

In the method and structures described above, a semiconductor material refers to a material whose conducting properties can be altered by doping with an impurity. Exemplary semiconductor materials include, for example, silicon-based semiconductor materials (e.g., silicon, silicon germanium, silicon germanium carbide, silicon carbide, etc.) and III-V compound semiconductors (i.e., compounds obtained by combining group III elements, such as aluminum (Al), gallium (Ga), or indium (In), with group V elements, such as nitrogen (N), phosphorous (P), arsenic (As) or antimony (Sb)) (e.g., GaN, InP, GaAs, or GaP). A pure semiconductor material and, more particularly, a semiconductor material that is not doped with an impurity for the purposes of increasing conductivity (i.e., an undoped semiconductor material) is referred to in the art as an intrinsic semiconductor. A semiconductor material that is doped with an impurity for the purposes of increasing conductivity (i.e., a doped semiconductor material) is referred to in the art as an extrinsic semiconductor and will be more conductive than an intrinsic semiconductor made of the same base material. That is, extrinsic silicon will be more conductive than intrinsic silicon; extrinsic silicon germanium will be more conductive than intrinsic silicon germanium; and so on. Furthermore, it should be understood that different impurities (i.e., different dopants) can be used to achieve different conductivity types (e.g., P-type conductivity and N-type conductivity) and that the dopants may vary depending upon the different semiconductor materials used. For example, a silicon-based semiconductor material (e.g., silicon, silicon germanium, etc.) is typically doped with a Group III dopant, such as boron (B) or indium (In), to achieve P-type conductivity, whereas a silicon-based semiconductor material is typically doped with a Group V dopant, such as arsenic (As), phosphorous (P) or antimony (Sb), to achieve N-type conductivity. A gallium nitride (GaN)-based semiconductor material is typically doped with magnesium (Mg) to achieve P-type conductivity and with silicon (Si) or oxygen to achieve N-type conductivity. Those skilled in the art will also recognize that different conductivity levels will depend upon the relative concentration levels of the dopant(s) in a given semiconductor region.

The terminology used herein is for the purpose of describing the disclosed structures and methods and is not intended to be limiting. For example, as used herein, the singular forms "a," "an," and "the" are intended to include the plural forms as well, unless the context clearly indicates otherwise. Additionally, as used herein, the terms "comprises," "comprising," "includes," and/or "including" specify the presence of stated features, integers, steps, operations, elements, and/or components, but do not preclude the presence or addition of one or more other features, integers, steps, operations, elements, components, and/or groups thereof. Furthermore, as used herein, terms such as "right," "left," "vertical," "horizontal," "top," "bottom," "upper," "lower," "under," "below," "underlying," "over," "overlying," "parallel," "perpendicular," etc., are intended to describe relative locations as they are oriented and illustrated in the drawings (unless otherwise indicated) and terms such as "touching," "in direct contact," "abutting," "directly adjacent to," "immediately adjacent to," etc., are intended to indicate that at least one element physically contacts another element (without other elements separating the described elements). The term "laterally" is used herein to describe the relative locations of elements and, more particularly, to indicate that an element is positioned to the side of another element as opposed to above or below the other element, as those elements are oriented and illustrated in the drawings. For example, an element that is positioned laterally adjacent to another element will be beside the other element, an element that is positioned laterally immediately adjacent to another element will be directly beside the other element, and an element that laterally surrounds another element will be adjacent to and border the outer sidewalls of the other element. The corresponding structures, materials, acts, and equivalents of all means or step plus function elements in the claims below are intended to include any structure, material, or act for performing the function in combination with other claimed elements as specifically claimed.

The method as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various disclosed embodiments have been presented for purposes of illustration but are not intended to be exhaustive or limiting. Many modifications and variations will be apparent to those of ordinary skill in the art without departing from the scope and spirit of the disclosed embodiments. The terminology used herein was chosen to best explain the principles of the embodiments, the practical application or technical improvement over technologies found in the marketplace, or to enable others of ordinary skill in the art to understand the embodiments disclosed herein.

In summary, a disclosed low noise amplifier (LNA) may include a common-emitter amplifier (CE-A), a common-gate amplifier (CG-A) and various passive devices in CE-A and CG-A. CE-A includes an NPN-type bipolar junction transistor (BJT) with emitter and collector (E/C) regions and a base region between the E/C regions and connected to an input node. CG-A includes P-channel field effect transistor (PFET) with source and drain (S/D) regions, a channel region between the S/D region, and a gate adjacent to the channel region. The drain region of the PFET is connected to an output node. Additionally, a common inductor, collector region of the BJT, and source region of the PFET are connected at an intermediate node. The LNA is implemented on a three-dimensional integrated circuit (3DIC) with the BJT and FET on different chips and with passive devices in back end of the line regions between the BJT and FET.

The following embodiments are explicitly disclosed.
Embodiment 1: A structure including:
   a bipolar junction transistor including: a base region connected to an input node; and a collector region; and
   a field effect transistor including: a source region connected to the collector region; and a drain region connected to an output node.
Embodiment 2: The structure of embodiment 1, wherein the bipolar junction transistor and the field effect transistor are on different chips of a three-dimensional integrated circuit and wherein interlayer dielectric material and metal levels of the different chips are between the bipolar junction transistor and the field effect transistor.
Embodiment 3: The structure of embodiment 1 or 2,
   wherein the bipolar junction transistor further includes an emitter region, and
   wherein the structure further includes:
      an emitter-base capacitor connected between the emitter region and the base region;
      an emitter inductor connected between the emitter region and ground; and
      a base inductor connected between the input node and the base region.
Embodiment 4: The structure of embodiment 3, wherein the base inductor is a tapered spiral inductor.
Embodiment 5: The structure of one of embodiments 1 to 4,
   wherein the field effect transistor further includes:
      a channel region between the source region and the drain region; and
      a gate adjacent to the channel region and connected to a bias voltage node, and
   wherein the structure further includes:
      a gate resistive element connected between the gate and the bias voltage node;
      a gate capacitor connected between the gate and ground;
      an output capacitor connected between the drain region and the output node; and
      a drain inductor connected between the drain region and ground.
Embodiment 6: The structure of one of embodiments 1 to 5, wherein the bipolar junction transistor is an NPN-type bipolar junction transistor and the base region includes silicon germanium and wherein the field effect transistor is a P-channel field effect transistor with a silicon active device region.
Embodiment 7: The structure of one of embodiments 1 to 6, further comprising a common inductor connected at one end to a positive voltage rail and at an opposite end to the collector region of the bipolar junction transistor and the source region of the field effect transistor.
Embodiment 8: A structure including:
   a bipolar junction transistor on a first chip, wherein the bipolar junction transistor includes a base region connected to an input node and a collector region; and
   a field effect transistor on a second chip, wherein the second chip is stacked on the first chip and wherein the field effect transistor includes: a source region connected to the collector region and a drain region connected to an output node.
   In some illustrative examples of embodiment 8, the structure of embodiment 8 may be defined with respect to embodiment as follows:
   The structure of one of embodiments 1 to 7, wherein the bipolar junction transistor is on a first chip, and
   wherein the field effect transistor is on a second chip, the second chip being stacked on the first chip.
Embodiment 9: The structure of embodiment 8,
   wherein the first chip includes first metal levels and the second chip includes second metal levels adjacent to the first metal levels,
   wherein the structure further includes passive elements, and
   wherein at least some of the passive elements are in the first metal levels and the second metal levels between the bipolar junction transistor and the field effect transistor.
Embodiment 10: The structure of embodiment 9,
   wherein the bipolar junction transistor further includes an emitter region, and
   wherein the passive elements include:
      an emitter-base capacitor connected between the emitter region and the base region;
      an emitter inductor connected between the emitter region and ground; and
      a base inductor connected between the input node and the base region.
Embodiment 11: The structure of embodiment 10, wherein the base inductor is a tapered spiral inductor with a first portion on the first chip and a second portion connected in parallel to the first portion and on the second chip.
Embodiment 12: The structure of one of embodiments 9 to 11,
   wherein the field effect transistor further includes:
      a channel region between the source region and the drain region; and
      a gate adjacent to the channel region and connected to a bias voltage node, and
   wherein the passive elements include:
      a gate resistive element connected between the gate and the bias voltage node;
      a gate capacitor connected between the gate and ground;
      an output capacitor connected between the drain region and the output node; and
      a drain inductor connected between the drain region and ground.
Embodiment 13: The structure of one of embodiments 9 to 12, wherein the passive elements further include a common inductor connected at one end to a positive voltage rail and at an opposite end to the collector region of the bipolar junction transistor and the source region of the field effect transistor.
Embodiment 14: The structure of one of embodiments 8 to 13, wherein the bipolar junction transistor is an NPN-type bipolar junction transistor and the base region includes silicon germanium and wherein the field effect transistor is a P-channel field effect transistor with a silicon active device region.
Embodiment 15: A structure including:
   a field effect transistor on a first chip; and
   a bipolar junction transistor on a second chip,
   wherein the second chip is stacked on the first chip,
   wherein the bipolar junction transistor includes a base region connected to an input node and a collector region, and
   wherein the field effect transistor includes: a source region connected to the collector region and a drain region connected to an output node.
   In some illustrative examples of embodiment 15, the structure of embodiment 15 may be defined with respect to embodiment 1 as follows:
   The structure of one of embodiments 1 to 7, wherein the field effect transistor is on a first chip, and
   wherein the bipolar junction transistor is on a second chip, the second chip being stacked on the first chip.
Embodiment 16: The structure of embodiment 15,
   wherein the first chip includes first metal levels and the second chip includes second metal levels adjacent to the first metal levels,
   wherein the structure further includes passive elements, and
   wherein at least some of the passive elements are in the first metal levels and the second metal levels between the field effect transistor and the bipolar junction.
Embodiment 17: The structure of embodiment 16,
   wherein the bipolar junction transistor further includes an emitter region, and
   wherein the passive elements include:
      an emitter-base capacitor connected between the emitter region and the base region;
      an emitter inductor connected between the emitter region and ground; and
      a spiral base inductor connected between the input node and the base region,
   wherein the spiral base inductor has a first portion on the first chip and a second portion connected in parallel to the first portion and on the second chip.
Embodiment 18: The structure of embodiment 16 or 17,
   wherein the field effect transistor further includes:
      a channel region between the source region and the drain region; and
      a gate adjacent to the channel region and connected to a bias voltage node, and
   wherein the passive elements include:
      a gate resistive element connected between the gate and the bias voltage node;
      a gate capacitor connected between the gate and ground;
      an output capacitor connected between the drain region and the output node; and
      a drain inductor connected between the drain region and ground.
Embodiment 19: The structure of one of embodiments 16 to 18, wherein the passive elements further include a common inductor connected at one end to a positive voltage rail and at an opposite end to the collector region of the bipolar junction transistor and the source region of the field effect transistor.
Embodiment 20: The structure of one of embodiments 15 to 19,
   wherein the field effect transistor is a P-channel field effect transistor with a silicon active device region, and
   wherein the bipolar junction transistor is an NPN-type bipolar junction transistor and the base region includes silicon germanium.

At least in the embodiments above, the term "include" and its variants may be interpreted as meaning that an embodiment includes stated features, while not necessarily excluding the presence of other features that are not explicitly stated.

## Claims

1. A structure including:
a bipolar junction transistor including: a base region connected to an input node; and a collector region; and
a field effect transistor including: a source region connected to the collector region; and a drain region connected to an output node.

2. The structure of claim 1, wherein the bipolar junction transistor and the field effect transistor are on different chips of a three-dimensional integrated circuit and wherein interlayer dielectric material and metal levels of the different chips are between the bipolar junction transistor and the field effect transistor.

3. The structure of claim 1 or 2,
wherein the bipolar junction transistor further includes an emitter region, and
wherein the structure further includes, preferably as passive elements:
an emitter-base capacitor connected between the emitter region and the base region;
an emitter inductor connected between the emitter region and ground; and
a base inductor connected between the input node and the base region.

4. The structure of claim 3, wherein the base inductor is a tapered spiral inductor.

5. The structure of one of claims 1 to 4,
wherein the field effect transistor further includes:
a channel region between the source region and the drain region; and
a gate adjacent to the channel region and connected to a bias voltage node, and
wherein the structure further includes, preferably as passive elements:
a gate resistive element connected between the gate and the bias voltage node;
a gate capacitor connected between the gate and ground;
an output capacitor connected between the drain region and the output node; and
a drain inductor connected between the drain region and ground.

6. The structure of one of claims 1 to 5, wherein the bipolar junction transistor is an NPN-type bipolar junction transistor and the base region includes silicon germanium and wherein the field effect transistor is a P-channel field effect transistor with a silicon active device region.

7. The structure of one of claims 1 to 6, further comprising a common inductor connected at one end to a positive voltage rail and at an opposite end to the collector region of the bipolar junction transistor and the source region of the field effect transistor.

8. The structure of one of claims 1 to 7, wherein the bipolar junction transistor is on a first chip, and
wherein the field effect transistor is on a second chip, the second chip being stacked on the first chip.

9. The structure of claim 8,
wherein the first chip includes first metal levels and the second chip includes second metal levels adjacent to the first metal levels,
wherein the structure further includes passive elements, and
wherein at least some of the passive elements are in the first metal levels and the second metal levels between the bipolar junction transistor and the field effect transistor.

10. The structure of claim 9,
wherein the bipolar junction transistor further includes an emitter region, and
wherein the passive elements include:
an emitter-base capacitor connected between the emitter region and the base region;
an emitter inductor connected between the emitter region and ground; and
a base inductor connected between the input node and the base region.

11. The structure of claim 10, wherein the base inductor is a tapered spiral inductor with a first portion on the first chip and a second portion connected in parallel to the first portion and on the second chip.

12. The structure of one of claims 1 to 7, wherein the field effect transistor is on a first chip, and
wherein the bipolar junction transistor is on a second chip, the second chip being stacked on the first chip.

13. The structure of claim 12,
wherein the first chip includes first metal levels and the second chip includes second metal levels adjacent to the first metal levels,
wherein the structure further includes passive elements, and
wherein at least some of the passive elements are in the first metal levels and the second metal levels between the field effect transistor and the bipolar junction.

14. The structure of claim 9 or 13,
wherein the bipolar junction transistor further includes an emitter region, and
wherein the passive elements include:
an emitter-base capacitor connected between the emitter region and the base region;
an emitter inductor connected between the emitter region and ground; and
a spiral base inductor connected between the input node and the base region,
wherein the spiral base inductor has a first portion on the first chip and a second portion connected in parallel to the first portion and on the second chip.

15. The structure of claim 9 or 13 or 14,
wherein the field effect transistor further includes a channel region between the source region and the drain region and a gate adjacent to the channel region and connected to a bias voltage node, the passive elements including a gate resistive element connected between the gate and the bias voltage node, a gate capacitor connected between the gate and ground, an output capacitor connected between the drain region and the output node, and a drain inductor connected between the drain region and ground; and/or
wherein the passive elements further include a common inductor connected at one end to a positive voltage rail and at an opposite end to the collector region of the bipolar junction transistor and the source region of the field effect transistor.
